(19)

Europäisches
Patentamt

European
Patent Office

Office européen
des brevets

(11) **EP 2 051 339 B1**

(12) **EUROPEAN PATENT SPECIFICATION**

(45) Date of publication and mention
of the grant of the patent:
**30.12.2009 Bulletin 2009/53**

(51) Int Cl.:
***H01R 13/648*** *(2006.01)*

(21) Application number: **07114688.0**

(22) Date of filing: **21.08.2007**

(54) **Connector**

Steckverbinder

Connecteur

(84) Designated Contracting States:
**AT BE BG CH CY CZ DE DK EE ES FI FR GB GR
HU IE IS IT LI LT LU LV MC MT NL PL PT RO SE
SI SK TR**

(43) Date of publication of application:
**22.04.2009 Bulletin 2009/17**

(73) Proprietor: **Giga-Byte Technology Co., Ltd.
Taipei-Hsien
231 (TW)**

(72) Inventors:
• **Lai, Tien-Ko
231 Taipei Hsien (TW)**

• **Uang, Muh-Jin
231 Taipei Hsien (TW)**
• **Chang, Chia-Cheng
231 Taipei Hsien (TW)**

(74) Representative: **Charrier, Rapp & Liebau
Patentanwälte
Postfach 31 02 60
86063 Augsburg (DE)**

(56) References cited:
**EP-A- 1 229 618     FR-A- 2 831 336
US-A- 6 059 983     US-B1- 6 241 537**

**Description**

**BACKGROUND OF THE INVENTION**

**Field of the Invention**

The invention relates to a connector, and more particularly to a connector for discharging electrostatic stress.

**Description of the Related Art**

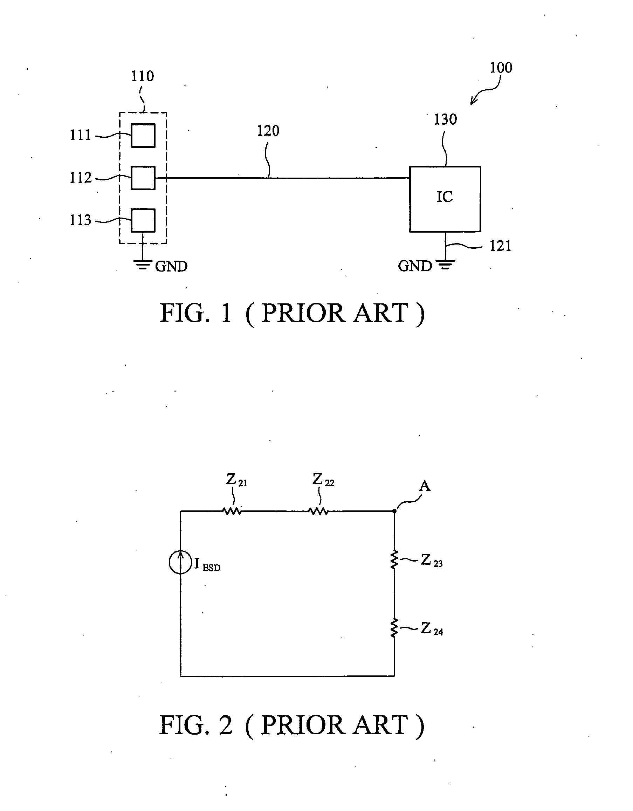

FIG. 1 is a schematic diagram of a conventional printed circuit board. Printed circuit board (PCB) 100 comprises a pad group 110, traces 120, 121, and an integrated circuit (IC) 130. Pad group 110 comprises pads 111-113 for welding with an input/output connector (not shown). Pad 112 electrically connects IC 130 via trace 120. Pad 113 is grounded.

Electrostatic charge is easily accumulated in human bodies due to friction or other causes. When a person having a large amount of electrostatic charge touches a cable connecting an input/output connector, the accumulated electrostatic charge enters IC 130 from pad 112 and trace 120. Thus, IC 130 is damaged.

FIG. 2 is an equivalent diagram of the convention PCB. Symbol $Z_{21}$ represents the impedance of the first half of trace 120. The first half of trace 120 approaches pad group 110. Symbol $Z_{22}$ represents the impedance of the second half of trace 120. The second half of impedance of trace 120 approaches IC 130. Symbol $Z_{23}$ represents the impedance of IC 130. Symbol $Z_{24}$ represents the impedance of trace 121.

When an electrostatic event occurs in pad 112, electrostatic current $I_{ESD}$ is generated. Voltage $V_{gen}$ of point A is expressed by the following equation (1):

$$V_{gen} = (Z_{23} + Z_{24}) \times I_{ESD}$$

If the electrostatic charge entering from the outside is not properly taken care of, the ICs welded in the PCB are damaged. Thus, the computer comprising the damaged ICs crashes.

FR 2 831 336 A1 discloses an electrical connector electrostatic protection system having a connector with metallic conductor pins held in an electrically isolating container. One pin is earth connected and the other connected to conductors. The connector box isolating support plate has a covering in conductor material deposited on the plate and contacting the earth pins, whilst surrounding the other pins. The covering has a pointed area defining an air gap allowing the electrostatic charge forces to dissipate, which leads to an complex design of the connector.

US 6,241,537 B1 discloses a connector assembly for a handheld computer including a plurality of conductive elements disposed on a first side of a printed circuit board housed with the handheld computer. One or more of the conductive elements has a pointed end.

EP 1 229 618 A2 discloses a discharge gap apparatus with a primary terminal including a primary discharge section for discharge and a secondary terminal including a secondary discharge section for discharge are arranged on a board at a distance from each other to satisfy an insulation standard. A floating-point terminal is provided between the primary terminal and the secondary terminal. A capacitor is connected between the floating-point terminal and the secondary terminal at a distance from the discharge sections. The interval at which the capacitor is connected is greater than the shortest distance between the secondary terminal and the floating-point terminal so as to satisfy the insulation standard.

US 6,059,983 discloses a method of fabricating an overcoated printed circuit board having a clean area free of contamination from the overcoating material. A metal-clad substrate is etched to form first and second printed circuit traces on the substrate. The first and second printed circuit traces define a channel having first and second ends. A layer of soldermask is deposited onto the substrate to cover a portion of the first and second printed circuit traces and to cover the channel except at an aperture. The aperture includes the intended clean area. The first and second printed circuit traces and the channel are covered with a capping device. An overcoating material is applied to the printed circuit board. During the applying step, the overcoating material is allowed to infiltrate into the channel under the capping device at the first and second ends, but is not allowed to reach the aperture. Counter pressure buildup inside the channel, caused by the infiltration itself, stops the overcoating material before it reaches the intended clean area. The capping device may be removed, or may remain in the assembly. Also disclosed is an application of the inventive method for forming spark gaps having various topologies, all including the just-described channel.

## BRIEF SUMMARY OF THE INVENTION

Connectors according to claim 1 are provided.

A detailed description is given in the following embodiments with reference to the accompanying drawings.

## BRIEF DESCRIPTION OF THE DRAWINGS

The invention can be more fully understood by referring to the following detailed description and examples with references made to the accompanying drawings, wherein:

FIG. 1 is a schematic diagram of a conventional printed circuit board;

FIG. 2 is an equivalent diagram of the conventional printed circuit board;

FIG. 3a is a schematic diagram of an exemplary embodiment of a printed circuit board;

FIG. 3b is a schematic diagram of an exemplary embodiment of protrudent parts;

FIG. 4 is an equivalent diagram of FIG. 3a; and

FIG. 5 is a schematic diagram of an exemplary embodiment of a connector.

## DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is best determined by reference to the appended claims.

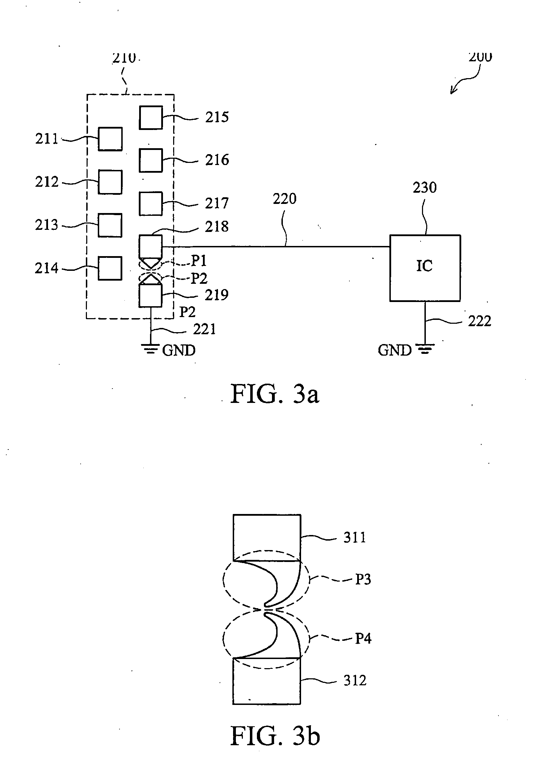

FIG. 3a is a schematic diagram of an exemplary embodiment of a printed circuit board which is not part of the invention. Printed circuit board (PCB) 200 comprises a pad group 210, traces 220-222, and an IC 230. Pad group 210 comprises pads 211-219 for welding with a connector (not shown). When the pins of the connector is welded to pads 211-219, if a connection line is utilized for connecting an external peripheral device and the connector, data can be transmitted between the external peripheral device and IC 230. In this embodiment, shapes of pads 211-219 are squares, but the disclosure is not limited thereto. In some embodiments, the shapes of pads 211-219 are circular or other shapes.

Pad 219 receives a power signal, such as a grounding signal. Pad 218 receives a data signal. Pad 218 comprises a side adjoining pad 219. The side of pad 218 comprises protrudent part P1. Pad 219 comprises a side adjoining pad 218. The side of pad 219 comprises protrudent part P2. Protrudent part P1 faces and approaches protrudent part P2. In this embodiment, the shapes of protrudent parts P1 and P2 are triangles, but are not limited to these. In some embodiments, only pad 218 receiving the data signal comprises a protrudent part P1 facing pad 219. Pad 219 does not comprise protrudent part P2. In one embodiment, only pad 219 receiving the power signal comprises protrudent part P2 and pad 218 receiving the data signal does not comprises protrudent part P1, wherein protrudent part P2 faces pad 218.

FIG. 3b is a schematic diagram of an exemplary embodiment of protrudent parts. The side of pad 311, facing pad 312, comprises protrudent part P3. The side of pad 312, facing pad 311, comprises protrudent part P4. Protrudent part P3 faces and approaches protrudent part P4. In this embodiment, protrudent parts P3 and P4 are arcs.

Referring to FIG. 3a, when a data signal is transmitted from an external peripheral device to IC 230 via pad 218, if an electrostatic event occurs in pad 218, the electrostatic current is released from protrudent parts P1, P2, pad 219, and trace 221 to ground. Since electrostatic current is immediately released by protrudent parts P1 and P2, trace 220 and IC 230 are not affected by the electrostatic current.

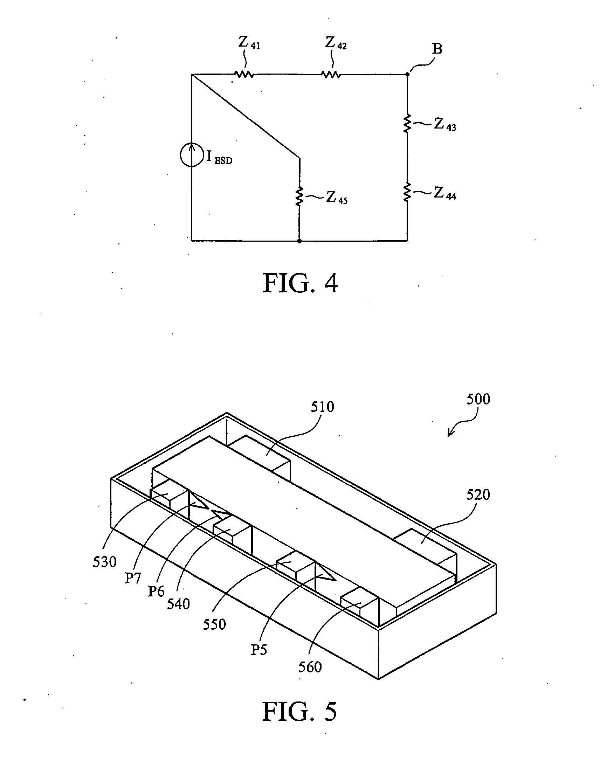

FIG. 4 is an equivalent diagram of FIG. 3a. Symbol $Z_{41}$ represents the impedance of the first half of trace 220. Symbol $Z_{42}$ represents the impedance of the second half of trace 220. Symbol $Z_{43}$ represents the impedance of IC 230. Symbol $Z_{44}$ represents the impedance of trace 222. Symbol $Z_{45}$ represents the impedance between protrudent part P1 and the ground.

When an electrostatic event occurs in pad 218, electrostatic current $I_{ESD}$ is generated. Voltage $V_{new}$ of point B is expressed by the following equation (2):

$$V_{new} = (Z_{43} + Z_{44}) \times \frac{I_{ESD} \times Z_{45}}{(Z_{41} + Z_{42} + Z_{43} + Z_{44} + Z_{45})} \tag{2}$$

Compared with equation (1), assuming impedances $Z_{23}$ and $Z_{24}$ equal to impedances $Z_{43}$ and $Z_{44}$, respectively. After calculating, voltage $V_{new}$ is less than voltage $V_{gen}$. Thus, the effect of the electrostatic event is reduced through protrudent parts P1 and P2 of pads 218 and 219. When the electrostatic voltage is higher, impedance $Z_{45}$ is reduced, thus, the electrostatic effect is reduced. Impedance $Z_{45}$ bases on the shapes of protrudent parts P1 and P2 and a distance between protrudent parts P1 and P2. Electrostatic tolerance of PCB 200 is controlled when protrudent parts P1 and P2 are controlled. Additionally, a region connecting pad 219 is paved with copper such that other pads may utilize peak discharge to release the electrostatic current to ground.

FIG. 5 is a schematic diagram of an exemplary embodiment of a connector according to the invention. Connector 500 comprises pins 510-560. In this embodiment, pins 530 and 560 transmit power signals, such as grounding signals. Pins 540 and 550 transmit data signals. The right side of pin 550, approaching pin 560, comprises protrudent part P5 for releasing the electrostatic current. Additionally, the side of pin 540, facing pin 530, comprises protrudent part P6. The side of pin 530, facing pin 540, comprises protrudent part P7. When an electrostatic event occurs in pin 540, the electrostatic current is released via protrudent parts P6 and P7.

While the invention has been described by way of example and in terms of the preferred embodiments, it is to be understood that the invention is not limited to the disclosed embodiments. To the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A connector (500), comprising:

   a first pin (540; 550) comprising a first side comprising a first protrudent part (P6; P5); and
   a second pin (530; 560) comprising a second side facing the first side, wherein the first protrudent part (P6; P5) approaches the second side for discharching electronic stress.

2. The connector (500) as claimed in claim 1, wherein the second side comprises a second protrudent part (P7) approaching the first protrudent part (P6).

3. The connector (500) as claimed in claim 2, wherein a data signal is transmitted by the first pin (540; 550) and a power signal is transmitted by the second pin (530; 560).

4. The connector (500) as claimed in claim 3, wherein the power signal is a grounding signal.

5. The connector (500) as claimed in claim 2, wherein the shape of the first protrudent part (P6; P5) is a first triangle and the shape of the second protrudent part (P7) is a second triangle.

6. The connector (500) as claimed in claim 5, wherein the peak of the first triangle approaches (P6) the peak of the second triangle (P7).

7. The connector (500) as claimed in claim 2, wherein the shape of the first protrudent part is a first arc and the shape of the second protrudent part is a second arc.

8. The connector (500) as claimed in claim 7, wherein a terminal of the first arc approaches a terminal of the second arc.

## Patentansprüche

1. Verbindungsstecker (500) mit:

   einem ersten Stift (540; 550) mit einer ersten Seite, die einen ersten vorstehenden Teil (P6, P5) umfasst; und
   einem zweiten Stift (530; 560) mit einer zweiten Seite, die der ersten Seite zugewandt ist, wobei sich der erste vorstehende Teil (P6; P5) der zweiten Seite nähert, um eine elektronische Belastung abzubauen.

2. Verbindungsstecker (500) nach Anspruch 1, wobei die zweite Seite einen zweiten vorstehenden Teil (P7) umfasst, der sich dem ersten vorstehenden Teil (P6) nähert.

3. Verbindungsstecker (500) nach Anspruch 2, wobei ein Datensignal durch den ersten Stift (540; 550) übertragen wird und ein Leistungssignal durch den zweiten Stift (530; 560) übertragen wird.

**4.** Verbindungsstecker (500) nach Anspruch 3, wobei das Leistungssignal ein Erdungssignal ist.

**5.** Verbindungsstecker (500) nach Anspruch 2, wobei die Form des ersten vorstehenden Teils (P6; P5) ein erstes Dreieck ist und die Form des zweiten vorstehenden Teils (P7) ein zweites Dreieck ist.

**6.** Verbindungsstecker (500) nach Anspruch 5, wobei sich die Spitze des ersten Dreiecks (P6) der Spitze des zweiten Dreiecks (P7) nähert.

**7.** Verbindungsstecker (500) nach Anspruch 2, wobei die Form des ersten vorstehenden Teils ein erster Bogen ist und die Form des zweiten vorstehenden Teils ein zweiter Bogen ist.

**8.** Verbindungsstecker (500) nach Anspruch 7, wobei sich ein Ende des ersten Bogens einem Ende des zweiten Bogens nähert.


## Revendications

**1.** Connecteur (500), comprenant :

une première broche (540 ; 550) comprenant une première face comprenant une première partie en saillie (P6 ; P5) ; et
une seconde broche (530 ; 560) comprenant une seconde face faisant face à la première face, dans lequel la première partie en saillie (P6 ; P5) se rapproche de la seconde face afin de décharger des contraintes électroniques.

**2.** Connecteur (500) selon la revendication 1, dans lequel la seconde face comprend une seconde partie en saillie (P7) se rapprochant de la première partie en saillie (P6).

**3.** Connecteur (500) selon la revendication 2, dans lequel un signal de données est transmis par la première broche (540 ; 550) et un signal de puissance est transmis par la seconde broche (530 ; 560).

**4.** Connecteur (500) selon la revendication 3, dans lequel le signal de puissance est un signal de masse.

**5.** Connecteur (500) selon la revendication 2, dans lequel la forme de la première partie en saillie (P6 ; P5) est un premier triangle et la forme de la seconde partie en saillie (P7) est un second triangle.

**6.** Connecteur (500) selon la revendication 5, dans lequel la crête du premier triangle (P6) se rapproche de la crête du second triangle (P7).

**7.** Connecteur (500) selon la revendication 2, dans lequel la forme de la première partie en saillie représente un premier arc et la forme de la seconde partie en saillie représente un second arc.

**8.** Connecteur (500) selon la revendication 7, dans lequel une extrémité du premier arc se rapproche d'une extrémité du second arc.

FIG. 1 ( PRIOR ART )

FIG. 2 ( PRIOR ART )

FIG. 3a

FIG. 3b

FIG. 4

FIG. 5

EP 2 051 339 B1

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- FR 2831336 A1
- US 6241537 B1
- EP 1229618 A2
- US 6059983 A